# EUROPEAN PATENT SPECIFICATION

(11) **EP 3 889 733 B1**
(45) Date of publication and mention of the grant of the patent: **10.01.2024**
(21) Application number: 20198765.8
(22) Date of filing: 28.09.2020
(51) Int. Cl.: G06F 1/16, H04M 1/02

(54) **METHODS AND DEVICES FOR DETECTING STATE OF FLEXIBLE SCREEN, ELECTRONIC DEVICE, AND STORAGE MEDIUM**
VERFAHREN UND VORRICHTUNGEN ZUR DETEKTION DES ZUSTANDS EINES FLEXIBLEN BILDSCHIRMS, ELEKTRONISCHE VORRICHTUNG UND SPEICHERMEDIUM
PROCÉDÉS ET DISPOSITIFS POUR DÉTECTER L'ÉTAT D'UN ÉCRAN FLEXIBLE, DISPOSITIF ÉLECTRONIQUE ET SUPPORT D'ENREGISTREMENT

(30) Priority: 03.04.2020 CN 202010257813
(43) Date of publication of application: 06.10.2021
(73) Proprietor: Beijing Xiaomi Mobile Software Co., Ltd., Beijing 100085 (CN)
(72) Inventor: CHEN, Chaoxi, Beijing, 100085 (CN)
(74) Representative: Hughes, Andrea Michelle

(56) References cited:
- CN-A- 110 360 921
- CN-A- 110 360 922

## Description

### TECHNICAL FIELD

The present disclosure generally relates to the technical field of electronics, and more particularly, to a method and device for detecting a state of a flexible screen, an electronic device, and a storage medium.

### BACKGROUND

Flexible screens have become one of the development trends of display screens of electronic devices. An electronic device with a flexible screen may be provided with a foldable part driving the flexible screen to be folded, thereby achieving various states for use. For example, the flexible screen may be unfolded to a state of a large display screen, the flexible screen is folded to reduce an area occupied by the electronic device and make it convenient to carry, or a secondary display screen may be arranged on an outer side of the electronic device in a folded state to display a simple picture such as time and the like; and therefore, the electronic device may be flexibly used in multiple manners.

However, under different states, different application interfaces in the use of the electronic device are required. Therefore, how to determine a state of a flexible screen of an electronic device becomes one of the important technical problems in the technology. Screen state detection techniques are disclosed in CN 110 360 922 and CN 110 360 921.

### SUMMARY

The present disclosure provides a method and device for detecting a state of a flexible screen, an electronic device, and a storage medium.

According to a first aspect of the present disclosure, an electronic device with a flexible screen is provided as defined by claim 1.

In some embodiments, the magnetic field sensor may include: at least two sensing elements, configured to detect magnetic fields in different directions and obtain detection parameters.

In some embodiments, the sensing elements may be Hall elements; extension directions of the at least two Hall elements may be mutually vertical; and the at least one detection parameter may include a Hall voltage sensed by the Hall element.

In some embodiments, the magnet may include a cylindrical permanent magnet, the cylindrical permanent magnet may include a solid cylindrical permanent magnet or a hollow cylindrical permanent magnet, and an interface of two magnetic poles of the cylindrical permanent magnet may overlap a tangent plane along any diameter of the cylindrical permanent magnet; or, the magnet may include a U-shaped permanent magnet, and an interface of two magnetic poles of the U-shaped permanent magnet may be a plane where a centerline of the U-shaped permanent magnet is located.

In some embodiments, in response to the flexible screen in an unfolded state, an interface of the two magnetic poles of the magnet may be parallel to the flexible screen.

In some embodiments, a length of the magnet along the axial direction of the rotating shaft may be greater than a length of the magnetic field sensor.

According to a second aspect of the present disclosure, a method for detecting a state of a flexible screen for an electronic device is provided as defined by claim 7.

[Deleted].

[Deleted].

[Deleted].

[Deleted].

[Deleted].

The technical solutions provided in the embodiments of the present disclosure may have the following beneficial effects. Through the technical solutions of the embodiments of the present disclosure, the magnetic field sensor is adopted to detect the magnetic field change of the magnet fixed on the rotating shaft to determine the state of the flexible screen, such that another component or application of the electronic device may conveniently perform corresponding data processing and the like according to the state of the flexible screen, and a simple and effective implementation solution is provided for state detection of the flexible screen.

It is to be understood that the above general descriptions and detailed descriptions below are only exemplary and explanatory and not intended to limit the present invention.

### BRIEF DESCRIPTION OF THE DRAWINGS

The accompanying drawings illustrate embodiments consistent with the present invention and, together with the description, serve to explain the principles of the present invention.
FIG. 1 is a structure diagram of an electronic device, according to an exemplary embodiment.
FIG. 2 is a structure diagram of a cylindrical magnet, according to an exemplary embodiment.
FIG. 3 is a structure diagram of a U-shaped magnet, according to an exemplary embodiment.
FIG. 4 is a flow chart showing a method for detecting a state of a flexible screen, according to an exemplary embodiment.
FIG. 5 is a physical structure block diagram of an electronic device, according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present invention. Instead, they are merely examples of apparatuses and methods consistent with aspects related to the present invention as recited in the appended claims.

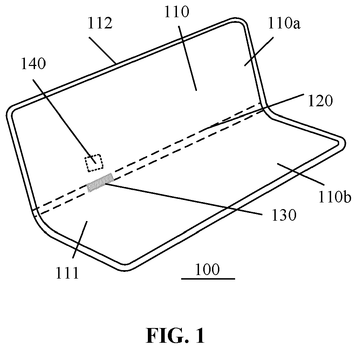

FIG. 1 is a structure diagram of an electronic device, according to an exemplary embodiment. As illustrated in FIG. 1, the electronic device 100 includes: a flexible screen 110, a rotating shaft 120, a magnet 130 and a magnetic field sensor 140. The flexible screen 110 may include a front surface 111 for displaying images and/or videos and a back surface 112 opposite to the front surface 111. The flexible screen 110 may include two sub-screens 110a and 110b configured to rotate about the rotating shaft 120.

The rotating shaft 120 is positioned on a back surface 112 of the flexible screen 110 and configured to change a state of the flexible screen 110 through rotation of the rotating shaft 120. The state of the flexible screen 110 may indicate the position, posture, or attitude of the flexible screen 110. For example, the state of the flexible screen 110 may include a folded state and an unfolded state, where the folded state may further include different states or positions with different folding angles between the two sub-screens 110a and 110b of the flexible screen 110.

The magnet 130 is at least partially fixed on the rotating shaft 120, and a connecting direction of two magnetic poles of the magnet 130 is vertical to an axial direction of the rotating shaft 120.

The magnetic field sensor 140 is positioned on the back surface of the flexible screen 110 and is configured to detect a magnetic field formed by the magnet 130 moving together with the rotating shaft 120 and obtain at least one detection parameter. The detection parameter is at least configurable to determine the state of the flexible screen 110.

In the embodiment of the present invention, the flexible screen covers a surface of the electronic device, and may be hidden in the electronic device, namely not exposed from an outer surface of the device, in a folded state. The flexible screen may display a picture as a full screen in an unfolded state. The rotating shaft is at a position where the flexible screen is folded on the back surface of the flexible screen, and rotates to drive the flexible screen to be folded, and then changes the state of the flexible screen.

The magnet is fixed at the rotating shaft and configured to generate the magnetic field. A direction of the magnetic field is vertical to the axial direction of the rotating shaft, such that the connecting line of the two magnetic poles, i.e., a pole N (north pole) and a pole S (south pole), of the magnet is vertical to the axial direction of the rotating shaft. The magnet may be a part of the rotating shaft. For example, a section of the rotating shaft is made from a magnetic material, thereby forming the magnet. The magnet may also be in the rotating shaft or enclose the rotating shaft. When rotating the rotating shaft, the magnet may simultaneously rotate along with the rotating shaft, thereby changing the connecting direction of the pole N and the pole S and rotating the direction of the magnetic field.

The magnetic field sensor is nearby the magnet and may sense the magnetic field generated by the magnet. The detection parameter may be a magnetic field intensity or the magnetic field direction. Therefore, when the magnet rotates along with the rotating shaft, the magnetic field sensor may detect a changed magnetic field intensity or direction. That is, the magnetic field sensor may detect a present magnetic field intensity or direction of the magnet, and thus a rotation angle of the rotating shaft may be determined according to the magnetic field direction to determine the state of the flexible screen.

It is to be noted that, no matter whether the magnet is in a rotating state or a stationary state, the magnetic field may be generated and the magnetic field sensor may detect the corresponding magnetic field. Therefore, in a rotating process of the rotating shaft, namely in a changing process of the state of the flexible screen of the electronic device, the magnetic field sensor may detect the changed magnetic field. When the flexible screen is fixed, namely the rotating shaft is stationary, the magnetic field sensor may detect the present magnetic field and further determine a present state of the flexible screen.

Through the abovementioned structure, the rotation angle of the rotating shaft may be determined accurately through the fixed magnet and the magnetic field sensor to determine the state of the flexible screen, such that another component or application of the electronic device may conveniently perform corresponding data processing and the like according to the state of the flexible screen.

In some embodiments, the magnetic field sensor includes: at least two sensing elements, configured to detect magnetic fields in different directions and obtain detection parameters.

In such an embodiment of the present invention, the magnetic fields in different directions may be sensed through the at least two sensing elements respectively, and the rotation angle of the rotating shaft may be obtained through detection parameters such as magnetic field intensities in different directions and the like. For example, an x-axis direction of a rectangular coordinate system is parallel to a surface of the flexible screen of the electronic device and vertical to the axial direction of the rotating shaft. A y-axis direction is the axial direction of the rotating shaft, and a z-axis direction is a direction vertical to a plane where the x axis and the y axis are located. Herein, magnetic field intensities may be detected in the x-axis direction and z-axis direction of the rectangular coordinate system respectively, and a rotation angle of the magnetic field direction may be obtained according to an arc tangent value of a ratio of the magnetic field intensities in the two directions, thereby determining the rotation angle of the rotating shaft.

In some embodiments, the sensing elements are Hall elements; extension directions of the at least two Hall elements are mutually vertical; and the detection parameter includes a Hall voltage sensed by the Hall element.

In such an embodiment of the present invention, the magnetic field sensor may utilize a Hall principle and detect the magnetic field intensity through the principle that a Hall element generates a Hall voltage under the action of a magnetic field. The mutually vertical Hall voltages are generated in the magnetic field through the at least two mutually vertical Hall elements, and then the rotation angle of the magnetic field may be determined according to an arc tangent value of a ratio of every two Hall elements, so as to determine the rotation angle of the rotating shaft.

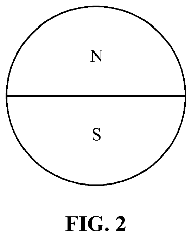

In some embodiments, as illustrated in FIG. 2, the magnet includes a cylindrical permanent magnet, the cylindrical permanent magnet includes a solid cylindrical permanent magnet or a hollow cylindrical permanent magnet, and an interface of two magnetic poles (N/S) of the cylindrical permanent magnet overlaps a tangent plane along any diameter of the cylindrical permanent magnet.

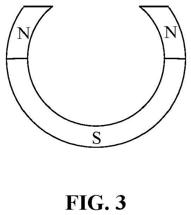

Or, as illustrated in FIG. 3, the magnet includes a U-shaped permanent magnet, and an interface of two magnetic poles (N/S) of the U-shaped permanent magnet is a plane where a centerline of the U-shaped permanent magnet is located.

When a shape of the magnet is a cylinder, a uniform magnetic field may be generated in a rotation direction of the rotating shaft, and the angle may be conveniently calculated. The U-shaped magnet is convenient to manufacture and generates a magnetic field similar to that generated by the cylindrical permanent magnet. Regardless of the shape of the magnet, the interface of the two magnetic poles is parallel to the axial direction of the rotating shaft. In this way, during the rotating process of the rotating shaft, the magnetic field generated by the magnet may change along with changing of the rotation angle, thereby bringing convenience to detection of the magnetic field sensor.

In some embodiments, when the flexible screen is in an unfolded state, an interface of the two magnetic poles of the magnet is parallel to the flexible screen.

When the interface of the two magnetic poles of the magnet is parallel to the flexible screen when the flexible screen is in the unfolded state, the rotation angle is 0 degree. Then, when the flexible screen is folded to a certain included angle along with rotation of the rotating shaft, the interface of the two magnetic poles of the rotating shaft is also correspondingly rotated by a certain angle. Therefore, the rotation direction is set in such a manner to bring convenience to data processing.

In some embodiments, a length of the magnet along the axial direction of the rotating shaft is greater than a length of the magnetic field sensor.

Since the intensity of the magnetic field generated by the magnet is directly proportional to a size of the magnet, for causing the magnetic field sensor to sense a sufficient magnetic field, the magnet requires a relatively large size. Herein, a relatively long magnet longer than the magnetic field sensor may be arranged in the axial direction, thereby causing the magnetic field sensor to sense the magnetic field generated by the magnet.

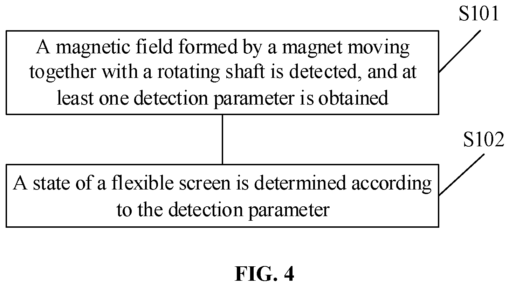

The embodiments of the present invention also provide a method for detecting a state of a flexible screen for an electronic device, which is applied to any abovementioned electronic device. As illustrated in FIG. 4, the method includes operations as follows.

At S 101, a magnetic field formed by a magnet moving together with a rotating shaft is detected, and at least one detection parameter is obtained.

At S102, a state of a flexible screen is determined according to the detection parameter.

Herein, the magnetic field generated by the magnet may be detected by use of a magnetic field sensor to obtain the detection parameter. The detection parameter may be detection parameters corresponding to magnetic field components in at least two directions. When rotating the rotating shaft and driving the flexible screen to be folded to form different included angles, magnitudes of the magnetic field components detected by the magnetic field sensor in different directions are different, such that a rotation angle of the rotating shaft may be determined so as to determine the state of the flexible screen.

In embodiments, the operation that the magnetic field formed by the magnet moving together with the rotating shaft is detected and the detection parameter is obtained includes that: magnetic fields in at least two different directions are detected, and induced voltages in the at least two different directions are obtained. The induced voltages are detection parameters, and the at least two different directions are mutually vertical.

Herein, a Hall effect detection principle is adopted for magnetic field detection. In a magnetic field environment, a semiconductor material (a Hall element) that a current is applied to may generate an electric potential difference, i.e., a Hall voltage, vertical to a direction of the current under the action of the magnetic field. Moreover, a magnitude of the Hall voltage is directly proportional to a magnetic field intensity. The abovementioned induced voltage is the Hall voltage generated by the Hall element under the action of the magnetic field.

Therefore, a component of the magnetic field intensity of the magnetic field in a direction may be determined by use of the magnitude of the detected induced voltage. Components of the magnetic field intensity in different directions may be detected by use of Hall elements in at least two different directions. Furthermore, an angle change of the magnetic field is further determined.

In embodiments, the operation that the state of the flexible screen is determined according to the detection parameter includes that: a rotation angle of the magnet is determined based on a mapping relationship between an arc tangent value of a ratio of the induced voltages in the at least two directions and the rotation angle of the magnet; and the state of the flexible screen is determined according to the rotation angle.

Directions of magnetic fields generated by the magnet under different rotation angles are also different, and correspondingly, detected induced voltages in the at least two directions are also different. Therefore, the rotation angle of the magnet may be determined according to the mapping relationship between the arc tangent value of the ratio of the induced voltages detected in the at least two directions in the abovementioned embodiment and the rotation angle so as to determine the state of the flexible screen. For example, when the rotation angle is 180 degrees, the flexible screen is in an unfolded state, and when the rotation angle is 0 degree, the flexible screen is in a folded state; or, when the rotation angle is 180 degrees, the flexible screen is in the folded state, and when the rotation angle is 0 degree, the flexible screen is in the unfolded state.

In some embodiments, the electronic device includes at least two magnets, and each magnet corresponds to at least one magnetic field sensor; the operation that the state of the flexible screen is determined according to the rotation angle includes that: an average rotation angle is determined according to rotation angles detected by each magnetic field sensor, and the state of the flexible screen is determined according to the average rotation angle.

In an embodiment of the present invention, the magnet and the magnetic field sensor correspondingly form a group of detection components. For improving the detection accuracy, multiple groups of detection components may be arranged in the electronic device, namely at least two magnets and corresponding magnetic field sensors are arranged. For example, two magnets are arranged at different positions, and each magnet corresponds to two magnetic field sensors. Of course, only one magnet may be arranged, and a magnetic field sensor is correspondingly arranged on each of two sides of the rotating shaft of the electronic device.

In such a manner, rotation angles of the rotating shaft are determined through detection data obtained by multiple magnetic field sensors, and may be averaged to obtain the average angle, such that data errors caused by arrangement of only one group of detection components are reduced, and the detection accuracy is improved.

The embodiments of the present invention also provide the following example.

An electronic device with a foldable flexible screen includes a rotating shaft configured to drive the flexible screen to be folded. By rotating the rotating shaft by a certain angle to fold the flexible screen, a certain included angle is formed by two surfaces. For detecting a folded state of the flexible screen, i.e., the state of the flexible screen, in an embodiment of the present invention, a groove may be formed in the rotating shaft and a magnet may be placed in the groove. An interface of north and south poles of the magnet is parallel to an axial direction of the rotating shaft. In this way, when the magnetic rotates along with the rotating shaft, a connecting direction of the north and south poles may also rotate along with the rotating shaft of the magnet, thereby bringing convenience to detection. In addition, the magnet and the magnetic field sensor may also be arranged on two sides of the rotating shaft respectively to implement state detection.

In an embodiment of the present invention, a magnetic field is detected by use of a digital Hall sensor which may be arranged on any side in the two sides of the rotating shaft. When rotating the rotating shaft and driving the flexible screen to be folded, voltage changes shaped like sinusoidal waves may be detected in three mutually vertical detection directions of the Hall sensor. An arc tangent value of a ratio of voltage signals detected in any two detection directions forms a fixed corresponding relationship with the rotation angle. Before the electronic device is delivered, the corresponding relationship is determined by experiments. In a practical using process of the electronic device, the corresponding rotation angle may directly be determined according to detected data, thereby determining the state of the flexible screen.

The rotating shaft may also be hollow, and the magnet is arranged in the rotating shaft. A shape of the magnet may be U and may also be a cylinder. A circle center of the cylinder overlaps a circle center of the rotating shaft, and a tangent plane where any diameter, passing through the circle center, of the magnet is located in the axial direction is the interface of the north and south poles of the magnet. When the flexible screen is in the unfolded state, an interface of north and south poles of the cylindrical magnet may be parallel to a plane where the flexible screen is located, and in such case, it may be determined that the angle is 0 degree.

Magnetic field intensities in at least two directions, for example, an x-axis direction and a z-axis direction, are detected, a tangent value of a ratio of the two or another function relationship is calculated, and multiple groups of data may be detected by rotation to obtain a function relationship between the detected magnetic field intensities and rotation angles, thereby obtaining function relationships between magnetic field components of the magnetic field in different directions and states of the flexible screen for convenient use.

The magnetic field sensor may be connected with a processing chip through an inter-integrated circuit (I2C) or another communication circuit. The magnetic field sensor may be arranged at a main board of the electronic device or a small power interface board.

However, it is to be noted that circuit lines around a position where the magnetic field sensor is arranged are required to be as few as possible, and a material for a component around it is also required to be relatively low in magnetic conductivity and unlikely to magnetize. Therefore, the magnetic field sensor and the magnet are unlikely to interfere with another component in the electronic device, and the condition of inaccurate detection caused by interference of the other component and circuit is also unlikely to occur.

In addition, for causing the magnetic field sensor to detect clear data, the intensity of the magnetic field may not be too low. Therefore, a size of the magnet is required to be large enough, including a relatively great radius and a relatively great length. For example, the length of the magnet may be greater than a length of the magnetic field sensor. In addition, for improving the detection accuracy, two magnetic field sensors may be arranged on two sides of one magnet, or multiple magnetic field sensors may be arranged on two sides of multiple magnets, and detection data is processed in an averaging manner, such that the detection accuracy is improved. Moreover, when one magnet or magnetic field sensor is damaged and disabled, standby magnets and magnetic field sensors are provided.

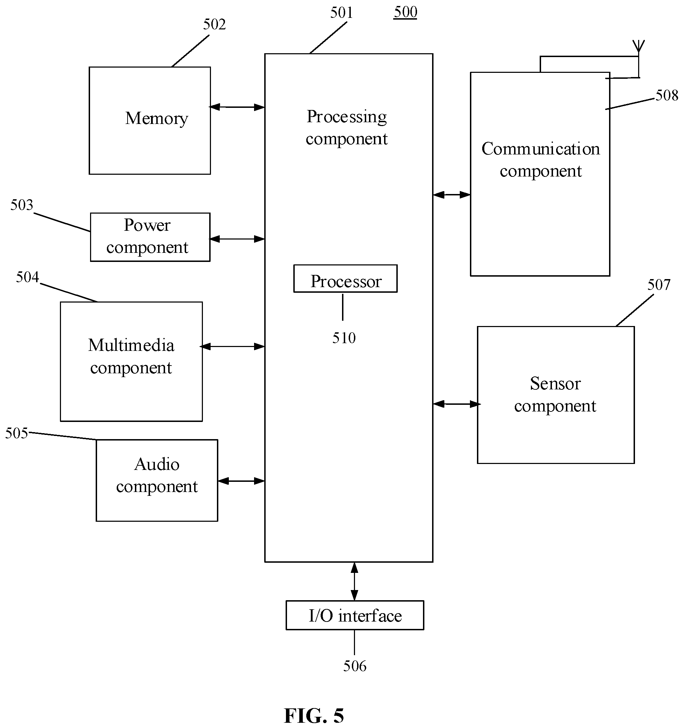

FIG. 5 is a physical structure block diagram of an electronic device 500, according to an exemplary embodiment. For example, the electronic device 500 may be a mobile phone, a computer, a digital broadcast terminal, a messaging device, a gaming console, a tablet, a medical device, exercise equipment, a personal digital assistant, and the like.

Referring to FIG. 5, the electronic device 500 may include one or more of the following components: a processing component 501, a memory 502, a power component 503, a multimedia component 504, an audio component 505, an input/output (I/O) interface 506, a sensor component 507, and a communication component 508.

The processing component 501 typically controls overall operations of the electronic device 500, such as the operations associated with display, telephone calls, data communications, camera operations, and recording operations. The processing component 501 may include one or more processors 510 to execute instructions to perform all or part of the steps in the abovementioned method. Moreover, the processing component 501 may further include one or more modules which facilitate interaction between the processing component 501 and other components. For instance, the processing component 501 may include a multimedia module to facilitate interaction between the multimedia component 504 and the processing component 501.

The memory 502 is configured to store various types of data to support the operation of the electronic device 500. Examples of such data include instructions for any applications or methods operated on the electronic device 500, contact data, phonebook data, messages, pictures, video, etc. The memory 502 may be implemented by any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, and a magnetic or optical disk.

The power component 503 provides power for various components of the electronic device 500. The power component 503 may include a power management system, one or more power supplies, and other components associated with generation, management and distribution of power for the electronic device 500.

The multimedia component 504 includes a screen providing an output interface between the electronic device 500 and a user. In some embodiments, the screen may include a liquid crystal display (LCD) and a touch panel (TP). If the screen includes the TP, the screen may be implemented as a touch screen to receive an input signal from the user. The TP includes one or more touch sensors to sense touches, swipes and gestures on the TP. The touch sensors may not only sense a boundary of a touch or swipe action, but also detect a period of time and a pressure associated with the touch or swipe action. In some embodiments, the multimedia component 504 includes a front camera and/or a rear camera. The front camera and/or the rear camera may receive external multimedia data when the electronic device 500 is in an operation mode, such as a photographing mode or a video mode. Each of the front camera and/or the rear camera may be a fixed optical lens system or have focusing and optical zooming capabilities.

The audio component 505 is configured to output and/or input an audio signal. For example, the audio component 505 includes a microphone (MIC), and the MIC is configured to receive an external audio signal when the electronic device 500 is in an operation mode, such as a call mode, a recording mode and a voice recognition mode. The received audio signal may further be stored in the memory 502 or sent through the communication component 508. In some embodiments, the audio component 505 further includes a speaker configured to output the audio signal.

The I/O interface 506 provides an interface between the processing component 501 and peripheral interface modules, such as a keyboard, a click wheel, buttons and the like. The buttons may include, but are not limited to: a home button, a volume button, a starting button and a locking button.

The sensor component 507 includes one or more sensors configured to provide status assessments in various aspects for the electronic device 500. For instance, the sensor component 507 may detect an on/off status of the electronic device 500 and relative positioning of components, such as a display and small keyboard of the electronic device 500, and the sensor component 507 may further detect a change in a position of the electronic device 500 or a component of the electronic device 500, presence or absence of contact between the user and the electronic device 500, orientation or acceleration/deceleration of the electronic device 500 and a change in temperature of the electronic device 500. The sensor component 507 may include a proximity sensor configured to detect presence of an object nearby without any physical contact. The sensor component 507 may also include a light sensor, such as a complementary metal oxide semiconductor (CMOS) or charge coupled device (CCD) image sensor, configured for use in an imaging application. In some embodiments, the sensor component 507 may also include an acceleration sensor, a gyroscope sensor, a magnetic sensor, a pressure sensor or a temperature sensor.

The communication component 508 is configured to facilitate wired or wireless communication between the electronic device 500 and other devices. The electronic device 500 may access a communication-standard-based wireless network, such as a wireless fidelity (WiFi) network, a 2nd-generation (2G) or 3rd-generation (3G) network or a combination thereof. In an exemplary embodiment, the communication component 508 receives a broadcast signal or broadcast associated information from an external broadcast management system through a broadcast channel. In an exemplary embodiment, the communication component 508 further includes a near field communication (NFC) module to facilitate short-range communications. For example, the NFC module may be implemented based on a radio frequency identification (RFID) technology, an infrared data association (IrDA) technology, an ultra-wide band (UWB) technology, a Bluetooth (BT) technology, and other technologies.

In an exemplary embodiment, the electronic device 500 may be implemented by one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors or other electronic components, and is configured to execute the abovementioned method.

In an exemplary embodiment, there is also provided a non-transitory computer-readable storage medium including instructions, such as included in the memory 502, executable by the processor 510 of the electronic device 500 for performing the abovementioned methods. For example, the non-transitory computer-readable storage medium may be a ROM, a random access memory (RAM), a compact disc read-only memory (CD-ROM), a magnetic tape, a floppy disc, an optical data storage device, and the like.

According to a non-transitory computer-readable storage medium, instructions in the storage medium are executed by a processor of a mobile terminal to cause the mobile terminal to execute any method in the abovementioned embodiment.

Other implementation solutions of the present invention will be apparent to those skilled in the art from consideration of the specification and practice of the present disclosure. This application is intended to cover any variations, uses, or adaptations of the present invention following the general principles thereof and including such departures from the present disclosure as come within known or customary practice in the art. It is intended that the specification and examples be considered as exemplary only, with the scope of the invention being defined by the following claims.

It will be appreciated that the present invention is not limited to the exact construction that has been described above and illustrated in the accompanying drawings, and that various modifications and changes may be made without departing from the scope thereof. It is intended that the scope of the invention only be limited by the appended claims.

## Claims

1. An electronic device (100), wherein the electronic device comprises:
a flexible screen (110);
a rotating shaft (120), positioned on a back surface (112) of the flexible screen (110) and configured to change a state of the flexible screen (110) through rotation of the rotating shaft (120), wherein the rotating shaft (120) is at a position where the flexible screen (110) is folded and rotates to drive the flexible screen to be folded;;
a magnet (130), at least partially fixed on the rotating shaft (120), a connecting direction of two magnetic poles of the magnet (130) being perpendicular to an axial direction of the rotating shaft (120); and
a magnetic field sensor (140), positioned on the back surface (112) of the flexible screen (110) and configured to detect a magnetic field formed by the magnet (130) moving together with the rotating shaft (120) and obtain at least one detection parameter, the at least one detection parameter indicating the state of the flexible screen (110);
wherein the magnetic field sensor (140) is configured to detect magnetic fields in at least two different directions and obtain induced voltages in the at least two different directions,
wherein the induced voltages are detection parameters and **characterized in that** the at least two different directions are mutually perpendicular; and
wherein a rotation angle of the magnet (130) is determined based on a mapping relationship between an arc tangent value of a ratio of the induced voltages in the at least two directions and the rotation angle of the magnet (130); and the state of the flexible screen (110) is determined according to the rotation angle.

2. The electronic device (100) of claim 1, wherein the magnetic field sensor (140) comprises: at least two sensing elements, configured to detect magnetic fields in different directions and obtain detection parameters.

3. The electronic device (100) of claim 2, wherein the sensing elements are Hall elements; extension directions of the at least two Hall elements are mutually perpendicular; and the at least one detection parameter comprises a Hall voltage sensed by a Hall element.

4. The electronic device (100) of any one of claims 1 to 3, wherein the magnet (130) comprises a cylindrical permanent magnet, the cylindrical permanent magnet comprises a solid cylindrical permanent magnet or a hollow cylindrical permanent magnet, and an interface of two magnetic poles of the cylindrical permanent magnet overlaps a tangent plane along any diameter of the cylindrical permanent magnet; or,
the magnet (130) comprises a U-shaped permanent magnet, and an interface of two magnetic poles of the U-shaped permanent magnet is a plane where a centerline of the U-shaped permanent magnet is located.

5. The electronic device (100) of claim 3, wherein, in response to the flexible screen (110) being in an unfolded state, an interface of the two magnetic poles of the magnet (130) is parallel to the flexible screen (110).

6. The electronic device (100) of any one of claims 1 to 3, wherein a length of the magnet (130) along the axial direction of the rotating shaft (120) is greater than a length of the magnetic field sensor (140).

7. A method for detecting a state of a flexible screen, applied to the electronic device of any one of claims 1 to 6, **characterized in that** the method comprises:
detecting (S101) a magnetic field formed by the magnet moving together with the rotating shaft, and obtaining at least one detection parameter; and
determining (S102) a state of the flexible screen according to the at least one detection parameter;
wherein detecting the magnetic field formed by the magnet moving together with the rotating shaft and obtaining the detection parameter comprises:
detecting magnetic fields in at least two different directions and obtaining induced voltages in the at least two different directions, wherein the induced voltages are detection parameters and the at least two different directions are mutually perpendicular;
wherein determining the state of the flexible screen according to the detection parameter comprises:
determining a rotation angle of the magnet based on a mapping relationship between an arc tangent value of a ratio of the induced voltages in the at least two directions and the rotation angle of the magnet; and
determining the state of the flexible screen according to the rotation angle.

8. The detection method of claim 7, wherein the electronic device comprises at least two magnets, and each magnet corresponds to at least one magnetic field sensor;
wherein determining the state of the flexible screen according to the rotation angle comprises:
determining an average rotation angle according to rotation angles detected by each magnetic field sensor, and
determining the state of the flexible screen according to the average rotation angle.

9. A computer-readable storage medium, in which computer-executable instructions are stored, the computer-executable instructions being executed by a processor to implement the steps in the method for detecting a state of a flexible screen of any one of claims 7 and 8.

## Patentansprüche

1. Elektronische Vorrichtung (100), wobei die elektronische Vorrichtung umfasst:
einen flexiblen Bildschirm (110);
eine Drehwelle (120), die an einer Rückfläche (112) des flexiblen Bildschirms (110) positioniert und so konfiguriert ist, dass sie einen Zustand des flexiblen Bildschirms (110) durch Drehung der Drehwelle (120) verändert, wobei sich die Drehwelle (120) an einer Position befindet, an der der flexible Bildschirm (110) gefaltet wird und sich dreht, um den flexiblen Bildschirm so anzutreiben, dass er gefaltet wird;
einen Magneten (130), der mindestens teilweise an der Drehwelle (120) befestigt ist, wobei eine Verbindungsrichtung von zwei Magnetpolen des Magneten (130) senkrecht zu einer axialen Richtung der Drehwelle (120) verläuft; und
einen Magnetfeldsensor (140), der an der Rückfläche (112) des flexiblen Bildschirms (110) positioniert und so konfiguriert ist, dass er ein von dem sich zusammen mit der Drehwelle (120) bewegenden Magneten (130) gebildetes Magnetfeld erkennt und mindestens einen Erkennungsparameter erhält, wobei der mindestens eine Erkennungsparameter den Zustand des flexiblen Bildschirms (110) angibt;
wobei der Magnetfeldsensor (140) so konfiguriert ist, dass er Magnetfelder in mindestens zwei verschiedenen Richtungen erkennt und induzierte Spannungen in den mindestens zwei verschiedenen Richtungen erhält, wobei die induzierten Spannungen Erkennungsparameter sind, und **dadurch gekennzeichnet, dass** die mindestens zwei verschiedenen Richtungen senkrecht zueinander verlaufen; und
wobei ein Drehwinkel des Magneten (130) auf Grundlage einer Abbildungsbeziehung zwischen einem Bogentangentenwert eines Verhältnisses der induzierten Spannungen in den mindestens zwei Richtungen und dem Drehwinkel des Magneten (130) bestimmt wird; und der Zustand des flexiblen Bildschirms (110) gemäß dem Drehwinkel bestimmt wird.

2. Elektronische Vorrichtung (100) nach Anspruch 1, wobei der Magnetfeldsensor (140) umfasst: mindestens zwei Sensorelemente, die so konfiguriert sind, dass sie Magnetfelder in verschiedenen Richtungen erkennen und Erkennungsparameter erhalten.

3. Elektronische Vorrichtung (100) nach Anspruch 2, wobei die Sensorelemente Hall-Elemente sind; Erstreckungsrichtungen der mindestens zwei Hall-Elemente senkrecht zueinander verlaufen; und der mindestens eine Erkennungsparameter eine von einem Hall-Element erfasste Hall-Spannung umfasst.

4. Elektronische Vorrichtung (100) nach einem der Ansprüche 1 bis 3, wobei der Magnet (130) einen zylindrischen Permanentmagneten umfasst, der zylindrische Permanentmagnet einen massiven zylindrischen Permanentmagneten oder einen hohlen zylindrischen Permanentmagneten umfasst, und eine Grenzfläche von zwei Magnetpolen des zylindrischen Permanentmagneten eine Tangentialebene entlang eines Durchmessers des zylindrischen Permanentmagneten überlappt;
oder
der Magnet (130) einen U-förmigen Permanentmagneten umfasst und eine Grenzfläche von zwei Magnetpolen des U-förmigen Permanentmagneten eine Ebene ist, in der sich eine Mittellinie des U-förmigen Permanentmagneten befindet.

5. Elektronische Vorrichtung (100) nach Anspruch 3, wobei als Reaktion darauf, dass sich der flexible Bildschirm (110) in einem aufgefalteten Zustand befindet, eine Grenzfläche der zwei Magnetpole des Magneten (130) parallel zum flexiblen Bildschirm (110) verläuft.

6. Elektronische Vorrichtung (100) nach einem der Ansprüche 1 bis 3, wobei eine Länge des Magneten (130) entlang der axialen Richtung der Drehwelle (120) größer ist als eine Länge des Magnetfeldsensors (140).

7. Verfahren zum Erkennen eines Zustands eines flexiblen Bildschirms, das auf die elektronische Vorrichtung nach einem der Ansprüche 1 bis 6 angewendet wird, **dadurch gekennzeichnet, dass** das Verfahren umfasst:
Erkennen (S101) eines Magnetfeldes, das von dem sich zusammen mit der Drehwelle bewegenden Magneten gebildet wird, und Erhalten mindestens eines Erkennungsparameters; und
Bestimmen (S102) eines Zustands des flexiblen Bildschirms gemäß dem mindestens einen Erkennungsparameter;
wobei Erkennen des Magnetfeldes, das von dem sich zusammen mit der Drehwelle bewegenden Magneten gebildet wird, und Erhalten des Erkennungsparameters umfasst:
Erkennen von Magnetfeldern in mindestens zwei verschiedenen Richtungen und Erhalten von induzierten Spannungen in den mindestens zwei verschiedenen Richtungen, wobei die induzierten Spannungen Erkennungsparameter sind und die mindestens zwei verschiedenen Richtungen senkrecht zueinander verlaufen;
wobei Bestimmen des Zustands des flexiblen Bildschirms gemäß dem Erkennungsparameter umfasst:
Bestimmen eines Drehwinkels des Magneten auf Grundlage einer Abbildungsbeziehung zwischen einem Bogentangentenwert eines Verhältnisses der induzierten Spannungen in den mindestens zwei Richtungen und dem Drehwinkel des Magneten; und
Bestimmen des Zustands des flexiblen Bildschirms gemäß dem Drehwinkel.

8. Erkennungsverfahren nach Anspruch 7, wobei die elektronische Vorrichtung mindestens zwei Magnete umfasst, und jeder Magnet mindestens einem Magnetfeldsensor entspricht;
wobei Bestimmen des Zustands des flexiblen Bildschirms gemäß dem Drehwinkel umfasst:
Bestimmen eines durchschnittlichen Drehwinkels gemäß Drehwinkeln, die von jedem Magnetfeldsensor erkannt werden, und
Bestimmen des Zustands des flexiblen Bildschirms gemäß dem durchschnittlichen Drehwinkel.

9. Computerlesbares Speichermedium, in dem computerausführbare Anweisungen gespeichert sind, wobei die computerausführbaren Anweisungen von einem Prozessor ausgeführt werden, um die Schritte in dem Verfahren zum Erkennen eines Zustands eines flexiblen Bildschirms nach einem der Ansprüche 7 und 8 zu implementieren.

## Revendications

1. Dispositif électronique (100), dans lequel le dispositif électronique comprend :
un écran flexible (110) ;
un axe rotatif (120), positionné sur une surface arrière (112) de l'écran flexible (110) et configuré pour changer un état de l'écran flexible (110) par la rotation de l'axe rotatif (120), dans lequel l'axe rotatif (120) est dans une position où l'écran flexible (110) est plié et tourne pour amener l'écran flexible à se plier ;
un aimant (130), au moins partiellement fixé sur l'axe rotatif (120), une direction de connexion de deux pôles magnétiques de l'aimant (130) étant perpendiculaire à une direction axiale de l'axe rotatif (120) ; et
un capteur de champ magnétique (140), positionné sur la surface arrière (112) de l'écran flexible (110) et configuré pour détecter un champ magnétique formé par l'aimant (130) se déplaçant avec l'axe rotatif (120) et obtenir au moins un paramètre de détection, le au moins un paramètre de détection indiquant l'état de l'écran flexible (110) ;
dans lequel le capteur de champ magnétique (140) est configuré pour détecter des champs magnétiques dans au moins deux directions différentes et obtenir des tensions induites dans les au moins deux directions différentes, dans lequel les tensions induites sont des paramètres de détection et sont **caractérisées en ce que** les au moins deux directions différentes sont mutuellement perpendiculaires ; et
dans lequel un angle de rotation de l'aimant (130) est déterminé sur la base d'une relation de correspondance entre une valeur d'arc-tangente d'un rapport des tensions induites dans les au moins deux directions et l'angle de rotation de l'aimant (130) ; et l'état de l'écran flexible (110) est déterminé en fonction de l'angle de rotation.

2. Dispositif électronique (100) selon la revendication 1, dans lequel le capteur de champ magnétique (140) comprend : au moins deux éléments de détection, configurés pour détecter des champs magnétiques dans différentes directions et obtenir des paramètres de détection.

3. Dispositif électronique (100) selon la revendication 2, dans lequel les éléments de détection sont des éléments Hall ; les directions d'extension des au moins deux éléments Hall sont mutuellement perpendiculaires; et le au moins un paramètre de détection comprend une tension Hall détectée par un élément Hall.

4. Dispositif électronique (100) selon l'une quelconque des revendications 1 à 3, dans lequel l'aimant (130) comprend un aimant permanent cylindrique, l'aimant permanent cylindrique comprend un aimant permanent cylindrique plein ou un aimant permanent cylindrique creux, et une interface de deux pôles magnétiques de l'aimant permanent cylindrique chevauche un plan tangent le long d'un diamètre quelconque de l'aimant permanent cylindrique ;
ou,
l'aimant (130) comprend un aimant permanent en U, et une interface de deux pôles magnétiques de l'aimant permanent en U est un plan où se situe l'axe central de l'aimant permanent en U.

5. Dispositif électronique (100) selon la revendication 3, dans lequel, en réponse à l'écran flexible (110) étant dans un état déplié, une interface des deux pôles magnétiques de l'aimant (130) est parallèle à l'écran flexible (110).

6. Dispositif électronique (100) selon l'une quelconque des revendications 1 à 3, dans lequel une longueur de l'aimant (130) le long de la direction axiale de l'axe rotatif (120) est supérieure à une longueur du capteur de champ magnétique (140).

7. Procédé de détection d'un état d'un écran flexible, appliqué au dispositif électronique selon l'une quelconque des revendications 1 à 6, **caractérisé en ce que** le procédé comprend :
la détection (S101) d'un champ magnétique formé par l'aimant se déplaçant avec l'axe rotatif, et l'obtention d'au moins un paramètre de détection ; et
la détermination (S102) d'un état de l'écran flexible en fonction du au moins un paramètre de détection ;
dans lequel la détection du champ magnétique formé par l'aimant se déplaçant avec l'axe rotatif, et l'obtention du paramètre de détection comprend :
la détection de champs magnétiques dans au moins deux directions différentes et l'obtention de tensions induites dans les au moins deux directions différentes, dans lequel les tensions induites sont des paramètres de détection et les au moins deux directions différentes sont mutuellement perpendiculaires ;
dans lequel la détermination de l'état de l'écran flexible en fonction du paramètre de détection comprend :
la détermination d'un angle de rotation de l'aimant sur la base d'une relation de correspondance entre une valeur d'arc-tangente d'un rapport des tensions induites dans les au moins deux directions et l'angle de rotation de l'aimant ; et
la détermination de l'état de l'écran flexible selon l'angle de rotation.

8. Procédé de détection selon la revendication 7, dans lequel le dispositif électronique comprend au moins deux aimants, et chaque aimant correspond à au moins un capteur de champ magnétique ;
dans lequel la détermination de l'état de l'écran flexible selon l'angle de rotation comprend :
la détermination d'un angle de rotation moyen en fonction d'angles de rotation détectés par chaque capteur de champ magnétique, et
la détermination de l'état de l'écran flexible selon l'angle de rotation moyen.

9. Support de stockage lisible par ordinateur, dans lequel des instructions exécutables par ordinateur sont stockées, les instructions exécutables par ordinateur étant exécutée par un processeur pour mettre en oeuvre les étapes dans le procédé de détection d'un état d'un écran flexible selon l'une quelconque des revendications 7 et 8.
